# EUROPÄISCHE PATENTSCHRIFT

(11) **EP 0 525 692 B1**
(45) Veröffentlichungstag und Bekanntmachung des Hinweises auf die Patenterteilung: **27.03.1996**
(21) Anmeldenummer: 92112761.9
(22) Anmeldetag: 25.07.1992
(51) Int. Cl.: B26D 3/28, H05K 3/00

(54) **Vorrichtung zum Trennen und Abziehen einer auf einem Trägermaterial auflaminierten Folie**
Apparatus for separating and peeling a foil of a laminated carrier material
Dispositif pour séparer et enlever une feuille d'un matériau support laminé

(30) Priorität: 02.08.1991 DE 4125722
(43) Veröffentlichungstag der Anmeldung: 03.02.1993
(73) Patentinhaber: HOECHST AKTIENGESELLSCHAFT, D-65926 Frankfurt am Main (DE)
(72) Erfinder: Heist, Hans, W-6200 Wiesbaden (DE); Platzer, Stephen J. W., Dr. Dipl.-Chem., W-6228 Eltville-Erbacher (DE)

(56) Entgegenhaltungen:
- EP-A- 0 214 461
- EP-A- 0 286 961
- US-A- 4 752 346
- IBM TECNICAL DISCLOSURE BULLETIN Bd. 31, Nr. 7, Dezember 1988, ARMONK, NY. USA Seiten 212-217, XP000027000 "PEEL MACHINE FOR PRINTED CIRCUIT BOARDS"

## Beschreibung

Die Erfindung betrifft eine Vorrichtung zum Trennen und Abziehen einer auf einem Trägermaterial auflaminierten Folie, mit einer horizontalen Grundplatte und einer teilweise darüber im Abstand angeordneten, eine Abzugskante aufweisenden Platte, wobei die Grundplatte und die darüber angeordnete Platte einen ersten Spalt bilden.

Lichtempfindliche Schichten oder Lagen, wie beispielsweise belichtete Fotoresistschichten auf Leiterplatten oder Farbprüffolien, sind im allgemeinen durch Schutzfolien abgedeckt. Bei der Herstellung von Farbprüffolien und gedruckten Leiterplatten wird ein Substrat zuerst mit einem lichtempfindlichen Material beschichtet. Anschließend wird das Material mit einer durchsichtigen Folie abgedeckt. Dieses Laminat aus Folie und lichtempfindlicher Schicht wird dann bildweise durch eine Maske belichtet. Diese Belichtung bewirkt eine bildformende, unterschiedliche Adhäsion der fotoempfindlichen Schicht in der Weise, daß die belichteten Teile mit einer stärkeren Adhäsion auf dem Substrat haften als die unbelichteten Teile. Wenn die Schutzfolie und das Substrat voneinander getrennt werden, befindet sich beispielsweise ein Positivbild auf dem Substrat und ein Negativbild auf der Schutzfolie.

Bei der Herstellung von Leiterplatten für elektrische Schaltungen wird das Substrat mit einem lichtempfindlichen Trockenresistfilm laminiert. Mit Hilfe einer die elektrische Schaltung darstellenden Abbildungsmaske erfolgt die Belichtung des Trockenresistfilms und danach wird die Schutzfolie entfernt und der Trockenresistfilm in verschiedenen Verarbeitungsschritten entwickelt. Die Schutzfolie auf dem Trockenresistfilm ermöglicht eine weitgehende staubfreie Belichtung und den Transport der beschichteten Leiterplatten im gestapelten Zustand. Die Leiterplatten weisen im einzelnen einen oder mehrere Ränder auf, die frei von der auflaminierten Schutzfolie sind, so daß die Platte an diesen freien Rändern von Greifwerkzeugen oder manuell erfaßt werden kann.

Bei einigen Laminiervorgängen ist es erwünscht, eine Beschichtung von einer Oberfläche zu einer anderen Oberfläche vollständig zu übertragen, wie diese beispielsweise bei einer Übertragung einer gefärbten Harzschicht von einem Substrat auf ein Empfangsblatt der Fall ist. In einem solchen Fall werden das beschichtete Substrat und ein darauf gelegtes Empfangsblatt durch einen Laminierspalt von beheizten Laminierwalzen unter Druck hindurchgeführt. Anschließend werden das Substrat und das Empfangsblatt voneinander getrennt und dabei die gefärbte Harzschicht von dem Substrat auf das Empfangsblatt übertragen. Ein Problem bei derartigen Übertragungsverfahren besteht in der Unvollständigkeit der Übertragung der gefärbten Harzschicht.

Das US-Patent 4,752,346 beschreibt eine Vorrichtung und ein Verfahren zum Ablösen und Trennen von aufeinanderklebenden Folien. Die Vorrichtung umfaßt eine Plattform aus einem Metall oder aus einem Material, dessen Oberfläche mit einer elektrischleitenden Schicht ausgestattet ist. Über der Oberfläche befindet sich eine Leistenkante oder ein Keil. Sowohl die Leistenkante als auch die Plattformoberfläche sind elektrisch geerdet. Die Leistenkante ist über der Plattform mittels Stützen an jedem Ende der Leistenkante positioniert. Die Stützen, die von Federn umgeben sind, sind durch die Leistenkante hindurchgeführt und ragen über diese vor. Somit ist es möglich, daß zwischen der Unterseite der Leistenkante und der Oberfläche der Plattform ein variabler Spalt sich ausbilden kann, der es ermöglicht, daß unterschiedlich dicke Laminate aus Substrat und Folie zwischen der Leistenkante und der Oberfläche der Plattform hindurchgeführt werden können. So wird beispielsweise auf eine transparente Polyesterfolie mittels einer Kleberschicht eine gefärbte fotoempfindliche Schicht aufgebracht, die von einem Empfangsblatt abgedeckt ist. Diese Sandwich-Anordnung durchläuft den Spalt von Laminierwalzen und wird anschließend zwischen der Leistenkante und der Plattform der Abzugsvorrichtung eingeführt. Die transparente Polyesterfolie wird über die Leistenkante abgezogen, indem die Folie über den Kantenwinkel geknickt nach oben entlang der Schräge der Leistenkante geführt wird. Dadurch wird die Polyesterfolie von dem Empfangsblatt beziehungsweise der Empfangsfolie getrennt und es erfolgt eine Übertragung der Kleber- und der gefärbten fotoempfindlichen Schicht auf das Empfangsblatt.

Aus der DE-OS 34 43 939 ist ein Verfahren zum Entfernen der Schutzfolie von mit belichtetem Fotoresist laminierten Leiterplatten mit Hilfe eine flächenförmigen Haftelements bekannt, das auf die zu entfernende Schutzfolie geklebt und anschließend im wesentlichen Übereck von der Leiterplatte gezogen wird. Dabei wird die Leiterplatte durch eine Verdrehvorrichtung so justiert, daß sich zwischen der Vorderkante der Platte und der Normalen zur Transportrichtung ein Winkel von 0 ° < α <90 ° einstellt. Anschließend wird das vordere Eck der Platte sowohl ober- als auch unterseitig derart mit einem zweiseitig klebenden Haftelement versehen, daß über den Rand der Schutzfolie hinaus auch Teile der unbedeckten Platte erfaßt werden und die Schutzfolie mittels Walzen abgezogen werden kann. Die Vorrichtung zur Durchführung des Verfahrens umfaßt eine Transport- und Justiereinrichtung, durch welche der plattenförmige Körper aus seiner Transportrichtung in eine Arbeitsposition schwenkbar ist, desweiteren eine Einrichtung zum Auftragen eines zweiseitig klebenden Haftelements, das zangenförmig ausgebildet ist und plattenförmige Körper zur Aufnahmen von Lagerrrollen aufweist und eine Einrichtung zum Entfernen des Haftelements und der mit diesem verbundenen Schutzfolie des plattenförmigen Körpers. Diese Einrichtung weist achsparallel angeordnetes Walzensystem mit einer Einrichtung zur Konstanthaltung des Walzenabstandes auf.

Aus der DE-OS 33 39 723 ist ein Verfahren und eine Vorrichtung zum Ablösen der Schutzfolie von laminierten Leiterplatten bekannt, bei dem die laminierten Leiterplatten über Transportrollen laufend an der Ober- und Unterseite mit einem einseitig beleimten Klebeband versehen werden, wobei durch ein anschießendes Abziehen des aufgebrachten Klebebandes über eine Leistenkante, welche mit der Leiterplatte einen Abziehspalt bildet, die Schutzfolie abgelöst, abtransportiert und gespeichert wird. Die Leistenkante bildet zur Transportvorrichtung einen Winkel von 45° und die sich anschließende Fläche zur Plattenebene ebenfalls einen Winkel von 45°.

Bei den bekannten Vorrichtungen zum Ablösen einer Schutzfolie von einer laminierten Leiterplatte werden entweder ein kontinuierliches beziehungsweise endloses Klebeband oder einzelne, doppelseitig klebende Elemente verwendet, wodurch zusätzliches Material und erhebliche Materialmengen davon benötigt werden. Ferner sind vorab weitere Verfahrensschritte erforderlich, um entweder das Klebeband oder die Klebeelemente auf die Schutzfolie der Leiterplatte aufzubringen.

Aufgabe der Erfindung ist es, hier Abhilfe zu schaffen und eine Vorrichtung und ein Verfahren vorzuschlagen, bei denen ohne Klebeband oder Klebeelement ein sicheres vollständiges und vollautomatisches Ablösen einer Folie von einem Trägermaterial, auf dem eine oder mehrere lichtempfindliche Schichten aufgebracht sind, erfolgt.

Diese Aufgabe wird gemäß einer Vorrichtung nach dem Oberbegriff des Anspruchs 1 in der Weise gelöst, daß eine Trennvorrichtung entlang einer Spindel mit Hilfe eines Motors über das auf der Grundplatte aufliegende Laminat aus Folie und Trägermaterial, bis über die Platte hin und her verfahrbar ist, wobei die Trennvorrichtung gegenüber der Grundplatte in Vertikalrichtung verschiebbar ist, daß die Trennvorrichtung ein keilförmiges Trennmesser und ein darüber liegendes, mit dem Trennmesser einen parallelen, schräg zu der Horizontalen geneigten zweiten Spalt bildendes Element aufweist, wobei eine in den zweiten Spalt eingefädelte Folienecke im zweiten Spalt festklemmbar ist, und daß das Laminat während des Einfädelns einer losgelösten Folienecke mittels eines hin und her bewegbaren Stempels, der die Grundplatte vertikal durchsetzt, im ersten Spalt festklemmbar ist.

In Ausgestaltung der Erfindung ist die Trennvorrichtung an der Unterseite eines Winkelrahmens befestigt, in dessen vertikalem Schenke am unteren Ende eine Rolle drehbar gelagert ist.

In Weiterbildung der Erfindung bildet das Trennmesser die Unterseite dieses Spalts, der einen Winkel im Bereich von 5 bis 25°, insbesondere von 10 bis 20°, in Vorschubrichtung der Trennvorrichtung mit der Horizontalen einschließt.

Die weitere Ausgestaltung der Erfindung ergibt sich aus den Patentansprüchen 4 bis 11.

Die Aufgabe wird ebenfalls durch ein Verfahren nach Anspruch 12 gelöst.

Das Verfahren zum Trennen und Abziehen einer auf einem Trägermaterial auflaminierten Folie, wobei das Laminat aus Folie und Trägermaterial auf einer horizontalen Grundplatte aufgelegt und mit seiner Diagonalen in einer parallel zur Grundplatte verlaufenden Vorschubrichtung einer Trennvorrichtung ausgerichtet wird, besteht darin, daß, getrennt durch einen ersten Spalt, eine Platte oberhalb der Grundplatte so angeordnet ist, daß zumindest eine Folienecke des im ersten Spalt frei beweglichen Laminats nicht durch die Platte abgedeckt wird, daß das Laminat im ersten Spalt festgeklemmt wird und die Folienecke infolge einer Vorschubbewegung der Trennvorrichtung mit Hilfe eines keilförmigen Trennmessers der Trennvorrichtung von dem Trägermaterial losgelöst und in einen schräg zur Horizontalen verlaufenden, oberhalb des Trennmessers liegenden zweiten Spalt eingefädelt wird, daß während einer weiteren Vorschubbewegung das festgeklemmte Laminat freigegeben und die Folienecke selbstklemmend im zweiten Spalt festgehalten wird, wobei durch die weitere Vorschubbewegung und ein gleichzeitiges vertikales Abheben von der Grundplatte der über eine Schräge auf die Oberseite der Platte auflaufenden Trennvorrichtung die Folie vollständig von dem Trägermaterial abgezogen wird.

Weiter vorteilhafte Verfahrensschritte ergeben sich aus den Merkmalen der Ansprüche 13 und 14.

Im folgenden wird die Erfindung anhand eines zeichnerisch dargestellten Ausführungsbeispiels näher erläutert. Es zeigen:
- Figur 1: eine Seitenansicht der Vorrichtung nach der Erfindung, teilweise aufgebrochen,
- Figur 2: eine Draufsicht auf die Vorrichtung nach Figur 1,
- Figur 3: einen Schnitt durch einen Teil der Vorrichtung in Seitenansicht, in einer Stellung der Trennvorrichtung unmittelbar vor einer Folienecke, der von einem Trägermaterial abzulösenden Folie,
- Figur 4: in geschnittener Seitenansicht die auf eine Schräge einer Platte auflaufende Trennvorrichtung, mit in einem Spalt eingefädelter Folienecke, und
- Figur 5: in geschnittener Seitenansicht die auf die Oberseite der Platte aufgelaufene Trennvorrichtung, mit teilweise von dem Trägermaterial abgelöster Folie.

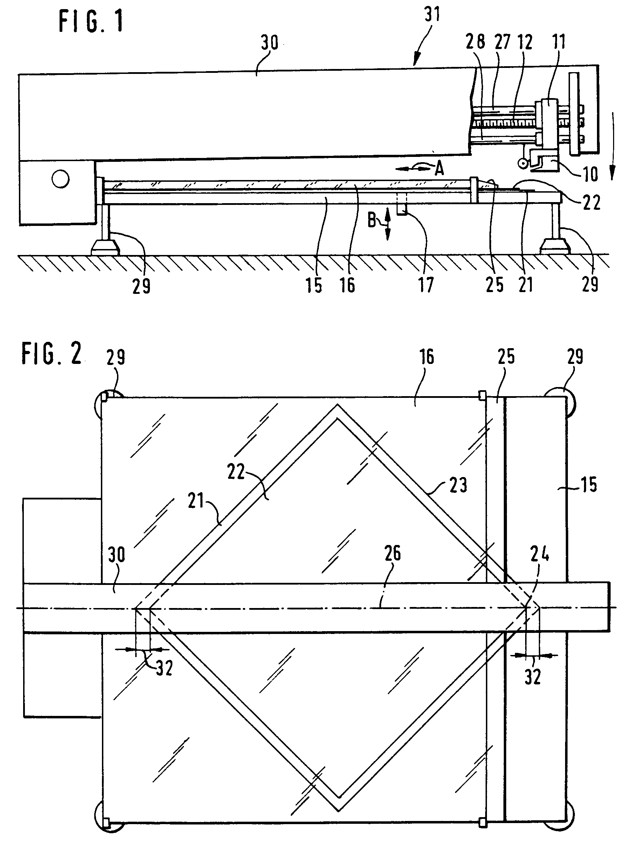

In Figur 1 ist eine Vorrichtung 31 zum Trennen und Abziehen einer Folie 22 von einem Trägermaterial 21 schematisch in Seitenansicht dargestellt. Die Vorrichtung 31 besteht aus einer Grundplatte 15, die sich auf vier Standbeinen 29 an den Ecken der Grundplatte abstützt, einer transparenten Platte 16, einer über einen Motor 11 angetriebenen Spindel 12, auf der eine Trennvorrichtung 10 aufsitzt und über die Grundplatte 15 hin und her verfahrbar ist, wie es der Doppelpfeil A zeigt sowie einem Stempel 17, der die Grundplatte 15 durchsetzt und angehoben und abgesenkt werden kann, wie dies der Doppelpfeil B andeutet. Die transparente Platte 16 ist über der Grundplatte 15 in einem bestimmten Abstand angeordnet und besitzt eine Schräge 25. In dem Spalt zwischen der Grundplatte 15 und der Platte 16 werden das Trägermaterial 21 mit der auflaminierten Folie 22 eingeschoben. Die Platte 16 deckt die Grundplatte 15, wie aus den Figuren 1 und 2 ersichtlich ist, nicht vollständig ab, sondern ist in Vorschubrichtung der Trennvorrichtung 10 kürzer als die Grundplatte 15.

Die Platte 16 besteht aus einem transparenten Material, beispielsweise Glas oder Kunststoff, wobei Glas bevorzugt wird. Das Trägermaterial 21 kann eine Folie sein, auf der beispielsweise eine gefärbte, lichtempfindliche Kunstharzschicht aufgebracht ist. Die darüber laminierte Folie 22 dient dann als Empfangsfolie für diese gefärbte Kunstharzschicht, die im allgemeinen eine Polymerschicht mit einem entsprechenden Farbstoff ist. Beim Ablösen und Trennen der Folie 22 von dem Trägermaterial 21 wird dann die gefärbte Kunstharzschicht von dem Trägermaterial auf die empfangende Folie 22 übertragen. Im Anschluß daran kann dann die Belichtung dieser so erhaltenen Farbprüffolie erfolgen.

Als Trägermaterial 21 kommt auch eine Leiterplatte mit aufbelichtetem Fotoresistmuster in Betracht, die Folie 22 ist dann eine Schutzfolie für das aufbelichtete Fotoresistmuster. Nach dem Belichten der Leiterplatte wird die Schutzfolie entfernt und das Fotoresistmuster in verschiedenen Bädern entwickelt. Die Schutzfolie muß entfernt werden, ohne daß es zu Beschädigungen des Fotoresistmusters kommt und/oder ohne daß Reste der Schutzfolie auf dem Fotoresistfilm verbleiben.

Wie aus Figur 1 ersichtlich ist, umgibt ein Gehäuse 30, das teilweise aufgebrochen gezeigt ist, die Spindel 12, parallel zu der Führungsstangen 27 und 28 verlaufen, entlang denen die Trennvorrichtung 10 verfahren wird.

Wie aus Figur 2 zu ersehen ist, ist die Folie 22 derart auf das Trägermaterial 21 auflaminiert, daß ringsum Ränder 32 des Trägermaterials 21 frei von der auflaminierten Folie 22 bleiben. Das Laminat 23 aus dem Trägermaterial 21 und der Folie 22 ist zwischen der Grundplatte 15 und der Platte 16 so angeordnet, daß die Diagonale 26 des rechteckigen oder quadratischen Laminats in Vorschubrichtung der Trennvorrichtung 10 ausgerichtet ist. Eine Folienecke 24 der Folie 22 liegt auf der Diagonale 26.

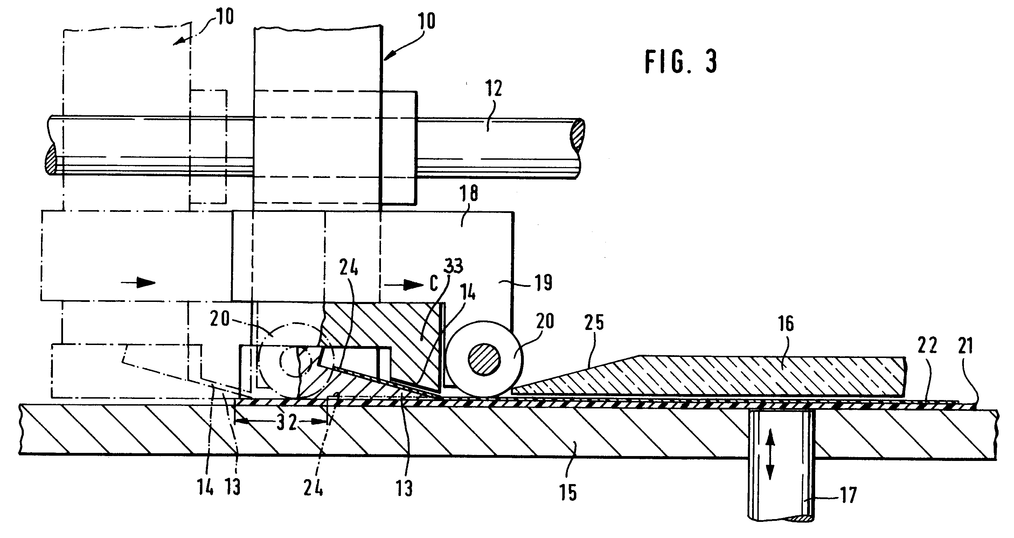

Aus Figur 3 ist zu ersehen, daß die Trennvorrichtung 10 ein keilförmige Trennmesser 13 aufweist, über dem sich ein dazu parallel und schräg verlaufender Spalt 14 befindet, den das Trennmesser 13 und ein Element 33 der Trennvorrichtung 10 bilden. In Figur 3 sind zwei Positionen der Trennvorrichtung 10 in Vorschubrichtung dargestellt. In der ersten, linken Position, strichpunktiert dargestellt, befindet sich die Trennvorrichtung 10 und damit das Trennmesser 13 kurz vor der Folienecke 24, eine Ablösung der Folienecke 24 von dem Trägermaterial 21 findet zu diesem Zeitpunkt noch nicht statt. Die Trennvorrichtung 10 ist an der Unterseite eines Winkelrahmens 18 befestigt, der einen horizontalen und vertikalen Schenkel aufweist. Im vertikalen Schenkel 19 ist am unteren Ende eine Rolle 20 drehbar gelagert, die während des Vorschubs zunächst über das Laminat 23 abrollt. In der zweiten, rechten Position in Figur 3 hat das keilförmige Trennmesser 13 die Folienecke 24 der Folie 22 von dem Trägermaterial 21 abgelöst und diese Folienecke 24 in den Spalt 14 eingefädelt. Die Rolle 20 befindet sich dann unmittelbar an der Vorderseite, d.h. am Beginn der Schräge 25 der Platte 16. Der Stempel 17, der die Grundplatte 15 vertikal durchdringt, drückt in dieser Position der Trennvorrichtung 10 das Laminat 23 gegen die Unterseite der Platte 16 und hält es fest, so daß die losgelöste Folienecke 24 ohne Schwierigkeiten in den Spalt 14 eingefädelt werden kann. Der Stempel 17 ist pneumatisch oder hydraulisch anhebbar und absenkbar. Die hierfür erforderliche pneumatische oder hydraulische Vorrichtung ist im Stand der Technik bekannt und daher in der Zeichnung nicht dargestellt.

Das Trennmesser 13 bildet gewissermaßen die Unterseite des Spalts 14, der einen Winkel im Bereich von 5 bis 25°, insbesondere von 10 bis 20° in Vorschubrichtung der Trennvorrichtung 10 mit der Horizontalen einschließt. In einem speziellen Ausführungsbeispiel beträgt der Winkel des Spalts mit der Horizontalen 15°. Die Spaltlänge ist gleich oder größer als 20 mm. Insbesondere eine Spaltlänge von 30 mm hat sich bei Versuchen als günstig erwiesen. Die Folienecke 24 wird im allgemeinen bis zu 20 mm in den Spalt eingefädelt. Während des weiteren Vorschubs der Trennvorrichtung wird die eingefädelte Folienecke 24 selbstklemmend von dem Trennmesser 13 im Spalt festgehalten.

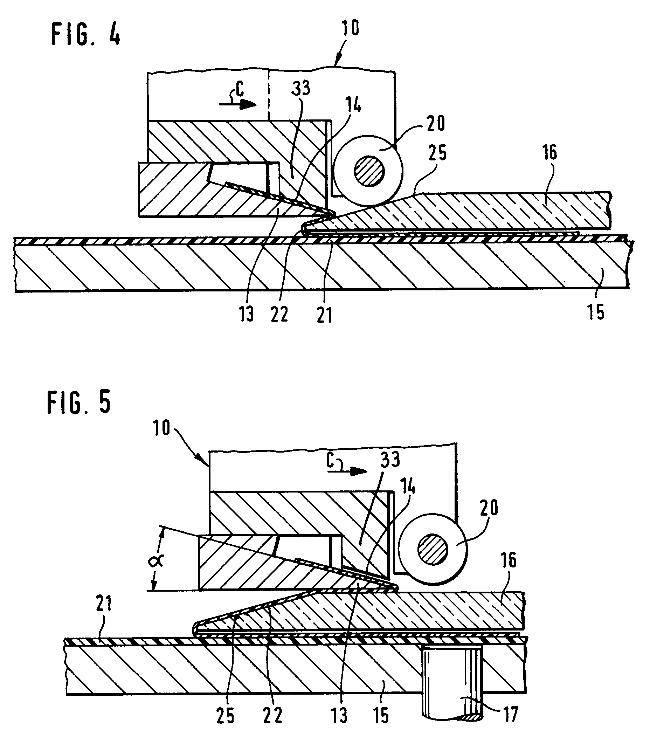

Figur 4 zeigt eine Position der Trennvorrichtung 10, in der sich die Rolle 20 auf der Schräge 25 der Platte 16 hochbewegt und dadurch die Trennvorrichtung 10 von dem Laminat 23 auf der Grundplatte 15 abhebt. In diesem Zusammenhang ist darauf hinzuweisen, daß die Trennvorrichtung 10 in Vertikalrichtung gegenüber der Grundplatte 15 verschiebbar ist. Die Folie 22 ist in dieser Stellung um die Vorderkante beziehungsweise um die Anfangskante der Schräge 25 geknickt herumgeführt und mit einem weiteren, dazu entgegengesetzten Knick in den Spalt 14 der Trennvorrichtung 10 eingefädelt. In dieser Position wird selbstverständlich das Laminat 23 durch den Stempel 17 nicht mehr festgehalten, der nach unten abgesenkt ist.

In Figur 5 ist eine Position der Trennvorrichtung 10 gezeigt, in der diese sich über die Oberfläche der Platte 16 entlang bewegt. Der Winkel α des keilförmigen Trennmessers 13 liegt in dem zuvor angegebenen Winkelbereich für den Spalt 14, beziehungswiese hat die gleiche Größe von 15° wie das voranstehend erwähnte bevorzugte Ausführungsbeispiel für den Spalt 14. In dieser Position ist die Rolle 20 von der Oberseite der Platte 16 abgehoben, was dadurch zustande kommt, daß der tiefste Punkt der Rolle 20, wie beispielsweise aus Figur 5 zu ersehen ist, über der Ebene der Horizontalfläche des keilförmigen Trennmessers 13 liegt. Diese Maßnahme ist erforderlich, damit das Trennmesser 13 problemlos die Folienecke 24 von dem Trägermaterial 21 loslösen kann. Aus Figur 5 ist auch ersichtlich, daß der Stempel 17 abgesenkt ist und keinen Kontakt mit der Unterseite des Laminats beziehungsweise des Trägermaterials hat. Die Vorschubrichtung der Trennvorrichtung 10 ist in den Figuren 3 bis 5 durch den Pfeil C angedeutet.

Das Abtrennen und Abziehen der Folie von dem Trägermaterial läuft wie folgt ab:
Das Laminat 23, bestehend aus der Folie 22 und dem Trägermaterial 21, wird diagonal zwischen der Grundplatte 15 und der mit geringem Abstand darüberliegenden Platte 16, die an der Einlaufseite die Schräge 25 aufweist, eingeschoben. Beim Start der Vorrichtung wird das Laminat 23 durch den Stempel 17 an der Unterseite festgehalten. Die obere, abzuziehende Folie 22 liegt diagonal gemessen ungefähr 2 cm hinter der Vorderkante des Trägermaterials 21, d.h. mit anderen Worten der von der Folie 22 freigelassene Rand 32 des Trägermaterials 21 beträgt 2 cm.

Auf dem Trägermaterial 21 schiebt sich das leicht angedrückte Trennmesser 13, über die Spindel 12 von dem Motor 11 angetrieben, in Richtung Vorderkante beziehungsweise Folienecke 24 der Folie 22 vor und löst die Folienecke 24 von dem Trägermaterial 21 ab. Die Folienecke 24 der Folie 22 schiebt sich ungefähr 20 mm in den über dem Trennmesser 13 gelegenen Spalt 14. Der von der Unterseite das Laminat 23 fixierende Stempel 17 wird in seine Ausgangslage zurückgeführt und gibt das Laminat frei. Anschließend läuft das Trennmesser 13 geführt von der Rolle 20, über die an der Vorderseite der Platte 16 befindliche Schräge 25 nach oben. Dadurch wird die in dem Spalt 14 über dem Trennmesser 13 befindliche Folie 22 in einem Winkel von 5 bis 20°, insbesondere von 15° umgeknickt und es entsteht ein selbstklemmender Halten zwischen dem Trennmesser 13 und der Folie 22 im Spalt 14.

Durch den weiteren Vorschub des Trennmessers 13 wird der Trennvorgang fortgesetzt und die beiden übereinanderlaminierten Teile lösen sich voneinander und werden in entgegengesetzte Richtungen voneinander getrennt.

## Patentansprüche

1. Vorrichtung zum Trennen und Abziehen einer auf einem Trägermaterial (21) auflaminierten Folie (22), mit einer horizontalen Grundplatte (15) und einer teilweise darüber im Abstand angeordneten, eine Abzugskante aufweisenden Platte (16), wobei die Grundplatte (15) und die darüber angeordnete Platte (16) einen ersten Spalt bilden, dadurch gekennzeichnet, daß eine Trennvorrichtung (10) entlang einer Spindel (12) mit Hilfe eines Motors (11) über das auf der Grundplatte (15) aufliegende Laminat (23) aus Folie (22) und Trägermaterial (21), bis über die Platte (16) hin und her verfahrbar ist, wobei die Trennvorrichtung (10) gegenüber der Grundplatte (15) in Vertikalrichtung verschiebbar ist, daß die Trennvorrichtung (10) ein keilförmiges Trennmesser (13) und ein darüberliegendes, mit dem Trennmesser (13) einen parallelen, schräg zu der Horizontalen geneigten zweiten Spalt (14) bildendes Element (33) aufweist, wobei eine in den zweiten Spalt (14) eingefädelte Folienecke (24) im zweiten Spalt festklemmbar ist, und daß das Laminat (23) wahrend des Einfädelns einer losgelösten Folienecke (24) mittels eines hin und her bewegbaren Stempels (17), der die Grundplatte (15) vertikal durchsetzt, im ersten Spalt festklemmbar ist.

2. Vorrichtung nach Anspruch 1, dadurch gekennzeichnet, daß die Trennvorrichtung (10) an der Unterseite eines Winkelrahmens (18) befestigt ist, in dessen vertikalem Schenkel (19) am unteren Ende eine Rolle (20) drehbar gelagert ist.

3. Vorrichtung nach Anspruch 1, dadurch gekennzeichnet, daß das Trennmesser (13) die Unterseite des Spalts (14) bildet, der einen Winkel im Bereich von 5 bis 25°, insbesondere von 10 bis 20° in Vorschubrichtung der Trennvorrichtung mit der Horizontalen einschließt.

4. Vorrichtung nach Anspruch 1, dadurch gekennzeichnet, daß die Spaltlänge größer/gleich 20 mm ist.

5. Vorrichtung nach Anspruch 4, dadurch gekennzeichnet, daß die Spaltlänge 30 mm beträgt.

6. Vorrichtung nach den Ansprüchen 1 und 2, dadurch gekennzeichnet, daß die der Trennvorrichtung (10) zugewandte Vorderseite der Platte (16) eine Schräge (25) aufweist, über die die Trennvorrichtung (10) mit Hilfe der Rolle (20) nach oben auf die Oberseite der Platte (16) läuft.

7. Vorrichtung nach Anspruch 1, dadurch gekennzeichnet, daß die Platte (16) aus einem transparenten Material wie Glas oder Kunststoff besteht.

8. Vorrichtung nach Anspruch 1, dadurch gekennzeichnet, daß der Stempel (17) pneumatisch oder hydraulisch anhebbar und absenkbar ist.

9. Vorrichtung nach Anspruch 1, dadurch gekennzeichnet, daß die auf dem Trägermaterial (21) auflaminierte Folie (22) eine Farbfolie ist und daß das Laminat (23) zwischen der Grundplatte (15) und der Platte (16) so angeordnet ist, daß die Diagonale (26) des rechteckigen oder quadratischen Laminats (23) in Vorschubrichtung der Trennvorrichtung (10) ausgerichtet ist.

10. Vorrichtung nach Anspruch 1, dadurch gekennzeichnet, daß das Trägermaterial (21) eine Folie ist.

11. Vorrichtung nach Anspruch 1, dadurch gekennzeichnet, daß das Trägermaterial (21) eine Leiterplatte mit aufbelichtetem Fotoresistmuster und die Folie (22) eine Schutzfolie ist.

12. Verfahren zum Trennen und Abziehen einer auf einem Trägermaterial (21) auflaminierten Folie (22), wobei das Laminat (23) aus Folie und Trägermaterial auf einer horizontalen Grundplatte (15) aufgelegt und mit seiner Diagonalen (26) in einer parallel zur Grundplatte verlaufenden Vorschubrichtung einer Trennvorrichtung (10) ausgerichtet wird, dadurch gekennzeichnet, daß, getrennt durch einen ersten Spalt, eine Platte (16) oberhalb der Grundplatte (15) so angeordnet ist, daß zumindest eine Folienecke (24) des im ersten Spalt frei beweglichen Laminats (23) nicht durch die Platte (16) abgedeckt wird, daß das Laminat im ersten Spalt festgeklemmt wird und die Folienecke infolge einer Vorschubbewegung der Trennvorrichtung (10) mit Hilfe eines keilförmigen Trennmessers (13) der Trennvorrichtung von dem Trägermaterial (21) losgelöst und in einen schräg zur Horizontalen verlaufenden, oberhalb des Trennmessers liegenden zweiten Spalt (14) eingefädelt wird, daß während einer weiteren Vorschubbewegung das festgeklemmte Laminat freigegeben und die Folienecke selbstklemmend im zweiten Spalt festgehalten wird, wobei durch die weitere Vorschubbewegung und ein gleichzeitiges vertikales Abheben von der Grundplatte der über eine Schräge (25) auf die Oberseite der Platte (16) auflaufenden Trennvorrichtung die Folie (22) vollständig von dem Trägermaterial abgezogen wird.

13. Verfahren nach Anspruch 12, dadurch gekennzeichnet, daß vor dem Loslösen der Folienecke die Unterseite des Laminats in einer von der Folienecke entfernten Stelle angehoben und das Laminat gegen die Unterseite der Platte angedrückt und dadurch festgehalten wird.

14. Verfahren nach den Ansprüchen 12 und 13, dadurch gekennzeichnet, daß das Laminat aus Folie und Trägermaterial freigegeben wird, sobald die losgelöste Folienecke in den Spalt der Trennvorrichtung eingefädelt und selbstklemmend festgehalten wird.

## Claims

1. An apparatus for separating and drawing off a film (22) laminated on a carrier material (21), comprising a base plate (15) and a plate (16) located partly thereabove at a distance and having a draw-off edge, the base plate (15) and the plate (16) located thereabove forming a first gap, characterized in that by means of a motor a separating apparatus (10) can be moved back and forth, along a spindle (12), over the laminate (23) comprised of film (22) and support material (21) and over the plate (16), the separating apparatus (10) being movable vertically relative to the base plate (15), in that the separating apparatus (10) comprises a wedge-shaped separating knife (13) and an element (33) positioned thereabove which together with the separating knife (13) forms a parallel second gap (14) obliquely inclined relative to the horizontal, it being possible to clamp a film corner (24) inserted into the second gap (14) into the second gap, and in that during the insertion of a detached film corner (24) the laminate (23) can be clamped in the first gap by means of a stay (17) which can be raised and lowered and passes through the base plate (15) vertically.

2. The apparatus as claimed in claim 1, wherein the separating apparatus (10) is fastened on the underside of an angled frame (13), in the vertical leg (29) of which a roller (20) is rotatably mounted at the lower end.

3. The apparatus as claimed in claim 1, wherein the separating knife (13) forms the underside of the gap (14), which includes an angle with the horizontal in the range from 5 to 25°, in particular from 10 to 20°, in the advancing direction of the separating apparatus.

4. The apparatus as claimed in claim 1, wherein the gap length is greater than/equal to 20 mm.

5. The apparatus as claimed in claim 4, wherein the gap length is 30 mm.

6. The apparatus as claimed in claims 1 and 2, wherein the front side of the plate (16) facing the separating apparatus (10) has a bevel (25), over which the separating apparatus (10) runs upward on the upper side of the plate (16) with the aid of the roller (20).

7. The apparatus as claimed in claim 1, wherein the plate (16) consists of a transparent material such as glass or plastic.

8. The apparatus as claimed in claim 1, wherein the stay (17) can be raised and lowered pneumatically or hydraulically.

9. The apparatus as claimed in claim 1, wherein the film (22) laminated on the carrier material (21) is a color film and wherein the laminate (23) is arranged between the base plate (15) and the plate (16) in such a way that the diagonal (26) of the rectangular or square laminate (23) is aligned in the advancing direction of the separating apparatus (10).

10. The apparatus as claimed in claim 1, wherein the carrier material (21) is a film.

11. The apparatus as claimed in claim 1, wherein the carrier material (21) is a circuit board with a photoresist pattern exposed on it and the film (22) is a protective film.

12. A process for separating and drawing off a film (22) laminated onto a carrier material (21), in which the laminate (23) comprised of film and carrier material is placed on a horizontal base plate (15) and is aligned with its diagonal (26) in the advancing direction of a separating apparatus (10), said direction running parallel relative to the base plate, characterized in that a plate (16), which is separated from the base plate (15) by a first gap, is positioned above the base plate (15) such that at least one film corner (24) of the laminate (23) which is freely movable in the first gap is not covered by the plate (16), that the laminate is clamped in the first gap and that the film corner is detached from the carrier material (21) with the aid of a separating knife (13) of the separating apparatus (10), as a result of an advance movement of the separating apparatus (10), and is threaded into a second gap (14) above the separating knife (13), running obliquely to the horizontal, that during a further advance movement the clamped-in laminate is released and the film corner is held firm in the second gap in a self-clamping manner, whereby the film (22) is completely drawn off the carrier material through the further advance movement and simultaneous vertical lifting off from the base plate of the separating apparatus running onto the upper side of the plate (16) over a bevel (15).

13. The process as claimed in claim 12, wherein, before detaching the film corner, the underside of the laminate is raised in a position remote from the film corner and the laminate is pressed against the underside of the plate and is thereby held firm.

14. The process as claimed in claims 12 and 13, wherein the laminate, comprising film and carrier material, is released as soon as the detached film corner is threaded into the gap of the separating apparatus and is held firm in a self-clamping manner.

## Revendications

1. Dispositif pour séparer et enlever une feuille (22) laminée sur un matériau support (21), comprenant une plaque d'assise (15) horizontale et une plaque (16) placée partiellement à distance au dessus par rapport à cette dernière et présentant une arête de tirage, la plaque d'assise (15) formant une première fente avec la plaque (16) placée au-dessus de cette dernière, caractérisé en ce qu'un dispositif de séparation (10) qui, par l'intermédiaire d'un moteur (11), se déplace d'avant en arrière et vice versa le long d'un arbre (12), au-dessus de l'aggloméré laminé (23), formé de la feuille (22) et du matériau support (21) et posé sur la plaque d'assise (15), jusqu'au-dessus de la plaque (16), le dispositif de séparation (10) pouvant être déplacé dans le sens vertical par rapport à la plaque d'assise (15), en ce que le dispositif de séparation (10) est muni d'un couteau de séparation (13) cunéiforme et d'un élément (33) placé au-dessus du couteau de séparation (13) et formant avec ce dernier une deuxième fente (14) inclinée en oblique par rapport à l'horizontale, un coin de la feuille (24) étant inséré et pouvant être bloqué dans la deuxième fente (14) et en ce que, pendant l'insertion d'un coin de la feuille (24) détaché, l'aggloméré laminé (23) peut être bloqué dans la première fente par l'intermédiaire d'un poinçon (17) traversant verticalement la plaque d'assise (15) par un mouvement de va et vient.

2. Dispositif selon la revendication 1, caractérisé en ce que le dispositif de séparation (10) est fixé sur la paroi inférieure d'un cadre (18) formé par des cornières, un rouleau (20) rotatif étant logé sur l'extrémité inférieure de la branche (19) verticale dudit cadre.

3. Dispositif selon la revendication 1, caractérisé en ce que le couteau de séparation (13) forme la face inférieure de la fente (14), laquelle inclut un angle compris entre 5 et 25°, en particulier entre 10 et 20° par rapport à l'horizontale, dans le sens de l'avance du dispositif de séparation.

4. Dispositif selon la revendication 1, caractérisé en ce que la longueur de la fente est supérieure ou égale à 20 mm.

5. Dispositif selon la revendication 4, caractérisé en ce que la longueur de la fente est de 30 mm.

6. Dispositif selon les revendications 1 et 2, caractérisé en ce que la face avant de la plaque (16) orientée vers le dispositif de séparation (10) présente un chranfrein (25) sur lequel se déplace, par l'intermédiaire du rouleau (20), le dispositif de séparation (10) pour monter sur la face supérieure de la plaque (16).

7. Dispositif selon la revendication 1, caractérisé en ce que la plaque (16) est fabriquée dans un matériau transparent tel que le verre ou une matière plastique.

8. Dispositif selon la revendication 1, caractérisé en ce que le poinçon (17) peut être soulevé et baissé par voie pneumatique ou hydraulique.

9. Dispositif selon la revendication 1, caractérisé en ce que la feuille (22) laminée sur le matériau support (21) est une feuille en couleur et en ce que l'aggloméré laminé (23) est disposé entre la plaque d'assise (15) et la plaque (16) de telle sorte que la diagonale (26) de l'aggloméré laminé (23) rectangulaire ou carré est orientée dans le sens de l'avance du dispositif de séparation (10).

10. Dispositif selon la revendication 1, caractérisé en ce que le matériau support (21) est une feuille.

11. Dispositif selon la revendication 1, caractérisé en ce que le matériau support (21) est une plaque conductrice avec un motif photorésist imprimé sur cette dernière par exposition à la lumière et la feuille (22) est une feuille de protection.

12. Procédé pour séparer et enlever une feuille (22) laminée sur un matériau support (21), l'aggloméré laminé (23), composé de la feuille et du matériau support, étant disposé sur une plaque d'appui (15) horizontale et orienté avec sa diagonale (26) dans le sens de l'avance d'un dispositif de séparation (10), parallèle par rapport à la plaque d'assise, caractérisé en ce qu'une plaque (16) est disposée au-dessus d'une plaque d'assise (15) en séparée par une première fente, de telle sorte qu'au moins un coin (24) de la feuille de l'aggloméré laminé (23) mobile dans la première fente n'est pas recouvert par la plaque (16), en ce que l'aggloméré laminé est serré dans la première fente et le coin de la feuille est détaché du matériau support (21) par suite d'un mouvement d'avance du dispositif de séparation (10), par l'intermédiaire du couteau de séparation (13) cunéiforme du dispositif de séparation, et s'engage dans une deuxième fente (14), située au-dessus du couteau de séparation et orientée en oblique par rapport à l'horizontale, en ce que, pendant un autre mouvement d'avance, l'aggloméré laminé serré est détaché et le coin de la feuille est serré par lui-même dans la deuxième fente, la feuille (22) étant totalement retirée du matériau support par le mouvement d'avance suivant et, simultanément, par le soulèvement vertical du dispositif de séparation qui se déplace de la plaque d'assise sur un chanfrein (25) de la face supérieure de la plaque (16).

13. Procédé selon la revendication 12, caractérisé en ce que, avant le détachement du coin de la feuille, la face inférieure de l'aggloméré laminé est soulevée en un point éloigné du coin de la feuille et l'aggloméré laminé est pressé contre la face inférieure de la plaque où il est, par conséquent, maintenu.

14. Procédé selon les revendications 12 et 13, caractérisé en ce que l'aggloméré laminé, composé de la feuille et du matériau support, est libéré dès que le coin de la feuille détaché s'insère et est serré par lui-même dans la fente du dispositif de séparation.
